# EUROPÄISCHE PATENTANMELDUNG

(11) **EP 4 468 744 A1**
(43) Veröffentlichungstag der Anmeldung: **27.11.2024**
(21) Anmeldenummer: 24175710.3
(22) Anmeldetag: 14.05.2024
(51) Int. Cl.: H04R 25/00, G01R 31/392

(54) **VERFAHREN ZUM ERMITTELN EINES ALTERUNGSZUSTANDES EINER BATTERIEZELLE IN EINEM HÖRINSTRUMENT**

(30) Priorität: 24.05.2023 DE 102023204852
(71) Anmelder: Sivantos Pte. Ltd., Singapore 539775 (SG)
(72) Erfinder: LER, Gee Heng, 539775 Singapur (SG); YAP, Heng Goh, 539775 Singapur (SG); TAN, Boon Siang, 539775 Singapore (SG); ONG, Chuan En Andrew, 539775 Singapore (SG); NG, Guan Hong, 539775 Singapur (SG)
(74) Vertreter: FDST Patentanwälte

(57) **Zusammenfassung**

Die Erfindung nennt ein Verfahren zum Ermitteln eines Alterungszustandes (SoH) einer Batteriezelle (20), welche in einem Hörinstrument (1) verwendet wird, wobei für eine Mehrzahl an Ladezyklen (a, b, n) jeweils durch ein Batteriemanagement (22) des Hörinstrumentes (1) eine auf die Batteriezelle (20) übertragene Ladung (On) ermittelt wird, durch das Batteriemanagement (22) eine Anzahl an Ladekennwerten (wn1, wn2) ermittelt werden, welche Aufschluss über die von besagter Ladung (On) bewirkte Änderung eines Ladezustands (ΔSoCn) der Batteriezelle liefert, und anhand der übertragenen Ladung (On) und besagter Anzahl an Ladekennwerten (wk1, wk2) ein Kapazitätskennwert (Ca, Cb, Cn) ermittelt wird, welcher eine Kenngröße für eine momentane Ladefähigkeit der Batteriezelle bildet, wobei durch einen Signalprozessor (12) des Hörinstrumentes (1) oder durch einen Signalprozessor (36) eines mit dem Hörinstrument (1) assoziierten Hilfsgerätes (34) an einem bestimmten Zeitpunkt die jeweiligen Kapazitätskennwerte (Ca, Cb, Cn) wenigstens einiger der vergangenen zehn Ladezyklen (a, b, n) gemittelt werden, und hieraus eine gemittelte Ladekapazität (Cavg) gebildet wird, und wobei die gemittelte Ladekapazität (Cavg) mit einem Referenzwert (Cref) verglichen wird, welcher eine Kenngröße für eine ursprüngliche Kapazität der Batteriezelle (20) bildet, und hieraus der Alterungszustand (SoH) der Batteriezelle (20) bestimmt wird.

## Beschreibung

Die Erfindung betrifft ein Verfahren zum Ermitteln eines Alterungszustandes einer Batteriezelle, welche in einem Hörinstrument verwendet wird.

Hörinstrumente werden zunehmend mit wiederaufladbaren Batteriezellen verwendet. Es ist dabei bekannt, dass mit zunehmender Anzahl an Ladezyklen die Kapazität der Batteriezelle abnimmt, diese also immer weniger Ladung speichern und somit auch weniger Ladung (und damit elektrische Leistung für den Betrieb) bereitstellen kann, wodurch die maximale Betriebsdauer des Hörinstrumentes abnimmt, bis ein erneuter Ladevorgang erforderlich wird. Man spricht hierbei auch von einer "Alterung" der Batterie.

Im Falle eines Kopfhörers als Hörinstrument, welcher vorrangig für Unterhaltungszwecke verwendet wird, mag es dabei noch akzeptabel für einen Benutzer erscheinen, den Betrieb vorzeitig auszusetzen, bis der nächste Ladevorgang möglich ist. Wird das Hörinstrument jedoch zur Versorgung einer Hörschwäche des Benutzers verwendet, also im Fall eines Hörgerätes (oder eines Kopfhörers mit zusätzlichen, benutzerspezifisch anpassbaren Hörgerätefunktionen), kann ein plötzliches Nachlassen der Batterieleistung jedoch sogar mit erheblichen Gefahren verbunden sein, etwa auf einer Straße, wenn infolge der ausbleibenden Hörunterstützung durch das Hörinstrument nahende Kraftfahrzeuge nicht mehr rechtzeitig wahrgenommen werden.

Somit ist eine ausreichende Batteriekapazität für einen sicheren Betrieb erforderlich, wozu eine zu stark gealterte Batterie im Zweifel zu ersetzen ist. Ein Benutzer wird jedoch auch vermeiden wollen, eine noch ausreichend funktionstüchtige Batterie zu ersetzen, um unnötige Kosten zu vermeiden.

Es ist daher Aufgabe der Erfindung, für ein Hörinstrument eine Möglichkeit bereitzustellen, einen Alterungszustand einer Batteriezelle möglichst präzise zu bestimmen.

Die genannte Aufgabe wird erfindungsgemäß gelöst durch ein Verfahren zum Ermitteln eines Alterungszustandes einer Batteriezelle in einem Hörinstrument, bzw. welche in einem Hörinstrument verwendet wird, wobei für eine Mehrzahl an Ladezyklen jeweils durch ein Batteriemanagement des Hörinstrumentes eine auf die Batteriezelle übertragene Ladung ermittelt wird, durch das Batteriemanagement eine Anzahl an Ladekennwerten ermittelt wird, welche Aufschluss über die von besagter Ladung bewirkte Änderung eines Ladezustands der Batteriezelle liefert, und anhand der übertragenen Ladung und besagter Anzahl an Ladekennwerten ein Kapazitätskennwert ermittelt wird, welcher eine Kenngröße für eine momentane Ladefähigkeit der Batteriezelle bildet.

Verfahrensgemäß ist hierbei vorgesehen, dass durch einen Signalprozessor des Hörinstrumentes oder durch einen Signalprozessor eines mit dem Hörinstrument assoziierten Hilfsgerätes an einem bestimmten Zeitpunkt die jeweiligen Kapazitätskennwerte wenigstens einiger der vergangenen zehn Ladezyklen gemittelt werden, und hieraus eine gemittelte Ladekapazität gebildet wird, und weiter die gemittelte Ladekapazität mit einem Referenzwert verglichen wird, welcher eine Kenngröße für eine ursprüngliche Kapazität der Batteriezelle bildet, und hieraus der Alterungszustand der Batteriezelle bestimmt wird. Vorteilhafte und teils für sich gesehen erfinderische Ausgestaltungen sind Gegenstand der Unteransprüche und der nachfolgenden Beschreibung.

Als ein Hörinstrument ist hierbei generell jedwede mobile, tragbare Vorrichtung umfasst, welche dazu eingerichtet ist, aus einem elektrischen Signal - welches auch durch ein internes Signal der Vorrichtung gegeben sein kann - ein Schallsignal zu erzeugen und einem Gehör eines Trägers dieser Vorrichtung zuzuführen, also insbesondere ein Kopfhörer (z.B. als "Earplug"), ein Headset, eine Datenbrille mit Lautsprecher, etc. Als ein Hörinstrument ist aber auch ein Hörgerät im engeren Sinne umfasst, also ein Gerät zur Versorgung einer Hörschwäche des Trägers, in welchem ein aus einem Umgebungssignal mittels eines Mikrofons erzeugtes Eingangssignal zu einem Ausgangssignal verarbeitet und dabei insbesondere frequenzbandabhängig verstärkt wird, und ein aus dem Ausganssignal mittels eines Lautsprechers o.ä. erzeugtes Ausgangsschallsignal dazu geeignet ist, insbesondere benutzerspezifisch die Hörschwäche des Trägers zumindest teilweise zu kompensieren.

Als Batteriezelle ist hierbei insbesondere jedwede wiederaufladbare Leistungsquelle des Hörinstruments umfasst, welche dazu vorgesehen und eingerichtet ist, im Normalbetrieb die Betriebsleistung des Hörinstruments bereitzustellen. Bevorzugt ist hierbei die Batteriezelle für einen Austausch vorgesehen und baulich konzipiert. Insbesondere stellt die Batteriezelle die kleinste einzeln austauschbare Einheit einer Leistungsquelle des Hörinstruments im o.g. Sinn dar.

Unter einem Alterungszustand der Batteriezelle ist hierbei insbesondere eine Verringerung der in einem Ladezyklus maximal erreichbaren Kapazität zu verstehen, welche mit einer zunehmenden Anzahl an Ladezyklen der Batteriezelle üblicherweise einhergeht. Dies bedeutet insbesondere, dass durch wiederholtes Laden der Batteriezelle die maximale Kapazität und dadurch auch die maximale Ladung, die nach dem Ladevorgang durch die Batteriezelle im Betrieb des Hörinstrumentes bereitgestellt werden kann, stetig geringer wird. Der Alterungszustand kann insbesondere ein quantitativer Kennwert für diese Verringerung sein, welcher die noch verfügbare, in einem Ladezyklus maximal erreichbare Kapazität in ein Verhältnis zu einem entsprechenden Referenz- und/oder Ausgangswert setzt, welcher die Kapazität bei einer Auslieferung und/oder Inbetriebnahme der Batteriezelle charakterisiert.

Unter einem Ladezyklus der Batteriezelle ist insbesondere ein Beladen über einen vorgegebenen Mindestzeitraum und/oder mit einer vorgegebenen Mindestladung umfasst, welche dabei auf die Batteriezelle übertragen werden muss. Wird also ein Ladevorgang in diesem Sinne vorzeitig (d.h. vor Erreichen der Mindestdauer oder der Mindest-Ladung) abgebrochen (z.B., weil der Benutzer das Hörinstrument unerwartet nutzen muss), so kann dies insbesondere als Ladezyklus vernachlässigt werden.

Das Hörinstrument umfasst hierbei ein Batteriemanagement, welches insbesondere definitionsgemäß als jedwede Vorrichtung anzusehen ist, welche beim Ladevorgang die Übertragung der elektrischen Leistung und Ladung auf die Batteriezelle steuert, und zudem bevorzugt auch die Abgabe der Batterieleistung aus der Batteriezelle für die Funktionen des Normalbetriebs während selbigem steuert.

In einer Mehrzahl an Ladezyklen wird nun durch das Batteriemanagement einerseits eine auf die Batteriezelle übermittelte Ladung ermittelt, und andererseits ermittelt, welche Änderung diese Ladung im Ladezustand der Batteriezelle jeweils bewirkt, wofür eine Anzahl an Ladekennwerten ermittelt wird. Diese Anzahl an Ladekennwerten liefert hierbei Aufschluss über besagte Änderung des Ladezustands, welche durch die übertragene Ladung bewirkt wird, wobei die bewirkte Änderung durch den oder die jeweiligen Ladekennwerte insbesondere in Relation zu einer instantanen maximalen Kapazität gesetzt wird, d.h., einen Bezug schafft zur jeweils vorliegenden maximalen Ladung, welche die Batteriezelle beim betreffenden Ladezyklus gerade aufnehmen (und entsprechend danach wieder bereitstellen) kann. Die Anzahl an Ladekennwerten kann dabei insbesondere in einer prozentualen Änderung der derzeitig maximal verfügbaren Kapazität der Batteriezelle gegeben sein, oder eine direkte Berechnung (oder auch ein Ermitteln anhand einer Tabelle) derselben ermöglichen.

Anhand der im Ladezyklus auf die Batteriezelle übertragenen Ladung sowie anhand der Anzahl an Ladekennwerten, welche die durch die übertragene Ladung jeweils bewirkte Änderung des Ladezustands charakterisieren, wird nun ein Kapazitätskennwert ermittelt. Der Kapazitätskennwert setzt dabei bevorzugt die Ladung und die durch diese bewirkte Änderung des Ladezustands in Relation, um so eine Kenngröße zu bilden für die momentane Ladefähigkeit der Batteriezelle, indem insbesondere eine Normierung über die Ladung erfolgt.

Beispielsweise wird für einen Ladezyklus als Anzahl an Ladekennwerten, oder anhand dieser, eine insbesondere prozentuale Veränderung des Ladezustands der Batteriezelle (bevorzugt bezogen auf die aktuelle maximale Kapazität) ermittelt, und anhand dieser und der übertragenen Ladung der Kapazitätskennwert ermittelt. Insbesondere kann hierfür die Veränderung des Ladezustands über der im Ladezyklus übertragenen Ladung normiert (bspw. durch einfache Division), um den Kapazitätskennwert des Ladezyklus zu erhalten. Durch die Normierung über der Ladung lässt dieser einen Rückschluss auf die momentane Ladefähigkeit, also insbesondere die momentan maximale Kapazität der Batteriezelle zu.

Durch einen Signalprozessor, welcher im Hörinstrument oder in einem mit dem Hörinstrument assoziierten und insbesondere drahtlos verbundenen Hilfsgerät angeordnet sein kann, werden nun für die vergangenen zehn, bevorzugt für die vergangenen dreißig Ladezyklen wenigstens einige, bevorzugt wenigstens fünf und besonders bevorzugt wenigstens die Hälfte der Kapazitätskennwerte gemittelt, wobei bevorzugt wenigstens zwei der aktuellsten fünf und besonders bevorzugt wenigstens zwei der aktuellsten vier Kapazitätskennwerte in den Mittelwert eingehen.

Aus diesem Mittelwert wird (im Signalprozessor) eine gemittelte Ladekapazität gebildet, welcher verglichen wird mit einem Referenzwert für die ursprüngliche Kapazität der Batteriezelle (und somit für die maximale bereitstellbare Ladung bei Auslieferung und/oder Inbetriebnahme der Batteriezelle), wobei der Referenzwert insbesondere gegeben sein kann durch eine entsprechende Herstellerangabe für die Kapazität der Batteriezelle.

Der Signalprozessor kann hierbei insbesondere durch denjenigen Prozessor (z.B. CPU) des Hörinstrumentes oder des Hilfsgerätes gegeben sein, welcher dazu vorgesehen und eingerichtet ist, im bestimmungsgemäßen Betrieb des Hörinstrumentes bzw. des Hilfsgerätes die Rechenleistung für dessen jeweilige Signalverarbeitung und/oder sonstige Hauptfunktionen bereitzustellen.

Die Kapazitätskennwerte geben für den zugehörigen Ladezyklus jeweils Aufschluss über die momentane Ladefähigkeit zum Zeitpunkt des Ladezyklus. Durch das Mitteln der Kapazitätskennwerte für die unmittelbar vergangenen Ladezyklen können dabei einerseits Fehler verringert werden, welche z.B. bei der Bildung der Kapazitätskennwerte durch eine diskrete Tabellierung der Ladekennwerte auftreten können. Andererseits ist eine Extrapolation der durch eine Ladung bewirkten Veränderung des Ladezustands auf die momentane Ladefähigkeit, also insbesondere die vollständige momentane Kapazität, gerade für ein unvollständiges oder vorzeitig beendetes Laden ggf. fehlerbehaftet, sodass auch hier die Mittelwertbildung den relativen Einfluss derartiger Fehler verringert. Zu guter Letzt fallen Ausreißer des Kapazitätskennwertes, welche ggf. infolge von ungewöhnlichen äußeren Bedingungen (wie z.B. Temperatur oder Luftfeuchtigkeit) einen leicht abweichenden Wert haben, weniger ins Gewicht.

Insgesamt lässt sich durch das beschriebene Verfahren der Alterungszustand der Batteriezelle ohne zusätzliche Geräte, ggf. mit Ausnahme eines ohnehin für den gemeinsamen Betrieb zusammen mit dem Hörinstrument vorgesehenen Hilfsgerätes, präzise ermitteln.

Zweckmäßigerweise werden für den jeweiligen Ladezyklus als die Anzahl an Ladekennwerten ein zu Beginn des betreffenden Ladezyklus' vorliegender Startwert einer Batteriespannung der Batteriezelle sowie ein am Ende des betreffenden Ladezyklus' vorliegender Endwert der Batteriespannung erfasst. Anhand der Batteriespannung lässt sich dann der jeweilige Ladezustand, insbesondere bezogen auf die momentane maximale Kapazität, anhand einer entsprechenden Funktion oder aus einer Tabelle ermitteln, sodass anhand des Startwertes der Batteriespannung ein Ausgangs-Ladezustand der Batteriezelle und anhand des Endwertes der Batteriespannung ein Abschluss-Ladezustand der Batteriezelle ermittelt werden kann, aus welchen die während des betreffenden Ladezyklus von der übertragenen Ladung bewirkte Änderung des Ladezustands der Batteriezelle ermittelt werden kann. Bevorzugt wird dabei der Ausgangs-Ladezustand bzw. der Abschluss-Ladezustand aus dem Startwert bzw. dem Endwert der Batteriespannung mittels einer Lookup-Tabelle ermittelt.

In einer alternativen Ausgestaltung werden für den jeweiligen Ladezyklus als die Anzahl an Ladekennwerten eine Mehrzahl an instantanen Werten der Batteriespannungen der Batteriezelle zu vorab festgelegten Zeitpunkten erfasst. Dies kann dahingehend von Vorteil sein, dass für den Ladezyklus eine größere Anzahl an Datenpunkten der Ladekennwerte vorliegt. Anhand der instantanen Werte der Batteriespannungen kann dann eine Mehrzahl entsprechender instantaner Ladezustände der Batteriezelle für die vorab festgelegten Zeitpunkte ermittelt werden, anhand derer wiederum die während des betreffenden Ladezyklus von der übertragenen Ladung bewirkte Änderung des Ladezustands der Batteriezelle ermittelt werden kann.

Als Batteriespannung werden hierbei vorzugsweise eine Leerlaufspannung und/oder eine Spannung einer Ladeschaltung und/oder eine Spannung einer Entladeschaltung erfasst. Diese Spannungen liefern, insbesondere im Vergleich mit einer entsprechenden Referenzspannung, einen besonders präzisen Aufschluss über einen momentanen Ladezustand der Batterie.

Das Mitteln der jeweiligen Kapazitätskennwerte erfolgt bevorzugt durch einen gewichteten und/oder rekursiven Mittelwert. Die entsprechenden Gewichte bzw. Rekursionsparameter können dabei derart gewählt werden, dass die Werte der jeweils aktuellsten Ladezyklen am stärksten in die gemittelte Ladekapazität eingehen. Insbesondere können die Gewichte hierfür auch in Abhängigkeit von Zeitabständen der Ladezyklen zueinander und/oder in Abhängigkeit einer Ladedauer des jeweiligen Ladezyklus und/oder einer dabei übertragenen Ladung gewählt werden.

Vorteilhafterweise wird als besagter Referenzwert ein initialer Wert für den besagten Kapazitätskennwert verwendet, welcher in einem der ersten zehn Ladezyklen, bevorzugt in einem der ersten fünf Ladezyklen nach Inbetriebnahme der Batteriezelle im Hörinstrument ermittelt wird, oder eine Herstellerangabe der ursprünglichen Kapazität. Erstgenannte Variante hat den Vorteil, dass die Bestimmung des Alterungszustandes unabhängiger von den Herstellerangaben wird. Letztgenannte Angabe erlaubt einen schlankeren Prozess.

Als weiter vorteilhaft erweist es sich, wenn für einen Ladezyklus ein Verwendungskriterium überprüft wird, und der Kapazitätskennwert des betreffenden Ladezyklus weiter in Abhängigkeit eines Bestehens des Verwendungskriteriums gebildet wird, und somit in besagter Abhängigkeit zur Bildung der gemittelten Ladefähigkeit herangezogen wird. Wird das Verwendungskriterium nicht bestanden, wird insbesondere der kapazitätskennwert des betreffenden Ladezyklus bei der Bildung der gemittelten Ladekapazität außer Acht gelassen.

Als Verwendungskriterium wird hierbei bevorzugt eine Ladedauer des Ladezyklus und/oder die während des Ladezyklus' übertragene Ladung und/oder der Endwert der Batteriespannung und/oder der Abschluss-Ladezustand der Batteriezelle überprüft. Somit kann sichergestellt werden, dass insbesondere zu kurze bzw. vorzeitig abgebrochene Ladezyklen und/oder solche Ladezyklen, bei welchen nicht ausreichend Ladung übertragen wurde, nicht herangezogen werden, sodass Fehler infolge zu nah beieinander liegender tabellierter Ladekennwerte o.ä. vermieden werden können.

Günstigerweise wird ein Kapazitätskennwert bei einer Mittelwertbildung für die gemittelte Ladekapazität vernachlässigt, wenn seine Abweichung vom Mittelwert einen vorgegebenen Grenzwert überschreitet. Dies ermöglicht es, statistische Ausreißer oder etwaige durch ungünstige Umgebungsbedingungen (wie Temperatur) zu stark beeinflusste Werte außer Acht zu lassen.

Als weiter vorteilhaft erweist es sich, wenn für die Bildung der gemittelten Ladekapazität die besagte Mehrzahl an Kapazitätskennwerten in einen First-In-First-Out-Speicher (FIFO-Speicher) gespeichert, welcher durch den Signalprozessor des Hörinstrumentes bzw. durch den Signalprozessor des mit dem Hörinstrument assoziierten Hilfsgerätes adressierbar ist, und/oder dessen Speicherkapazität genau der besagten Mehrzahl an Kapazitätskennwerten entspricht. Durch den FIFO-Speicher kann sichergestellt werden, dass einerseits nicht mehr Speicher als nötig für das Verfahren zugewiesen wird, und andererseits veraltete Werte sicher vernachlässigt werden und somit Datenfehler infolge fehlerhafter Zuweisungen vermieden werden.

Die Erfindung nennt weiter ein Hörsystem, welches ein Hörinstrument mit einer Batteriezelle und einem Batteriemanagement, sowie einen Signalprozessor umfasst, wobei das Hörsystem zur Durchführung des vorbeschriebenen Verfahrens eingerichtet ist.

Das erfindungsgemäße Hörsystem teilt die Vorzüge des erfindungsgemäßen Verfahrens. Die für das Verfahren und für seine Weiterbildungen angegebenen Vorteile können sinngemäß auf das Hörinstrument übertragen werden.

Insbesondere kann der Signalprozessor hierbei im Hörinstrument angeordnet sein, und einen Teil der dortigen Prozessorarchitektur bilden. In diesem Fall kann das Hörsystem auch allein durch das Hörinstrument gegeben sein.

In einer alternativen Ausgestaltung umfasst das Hörsystem ein mit dem Hörinstrument assoziiertes Hilfsgerät, welches besagten Signalprozessor aufweist. Das Hilfsgerät kann dabei bevorzugt durch ein Smartphone oder eine Smartwatch gegeben sein. Die für das Verfahren erforderlichen Berechnungsschritte können dann zumindest teilweise auf dem Hilfsgerät durchgeführt werden. Im genannten Fall eines Smartphones oder einer Smartwatch kann der Alterungszustand jeweils auf dem Bildschirm angezeigt werden.

Nachfolgend wird ein Ausführungsbeispiel der Erfindung anhand von Zeichnungen näher erläutert. Hierbei zeigen jeweils schematisch:
- Fig. 1: in einem Blockschaltbild ein Hörinstrument mit einer wiederaufladbaren Batteriezelle,
- Fig. 2: in einem Blockdiagramm ein Verfahren zum Bestimmen eines Alterungszustandes der Batteriezelle nach Fig. 1,
- Fig. 3: in einem Diagramm ein Zusammenhang zwischen der Batteriespannung der Batteriezelle nach Fig. 1 und dem Ladezustand, und
- Fig. 4: in einem Blockschaltbild ein Hörsystem mit dem Hörinstrument nach Fig. 1 und einem Hilfsgerät.

Einander entsprechende Teile und Größen sind in allen Figuren jeweils mit denselben Bezugszeichen versehen.

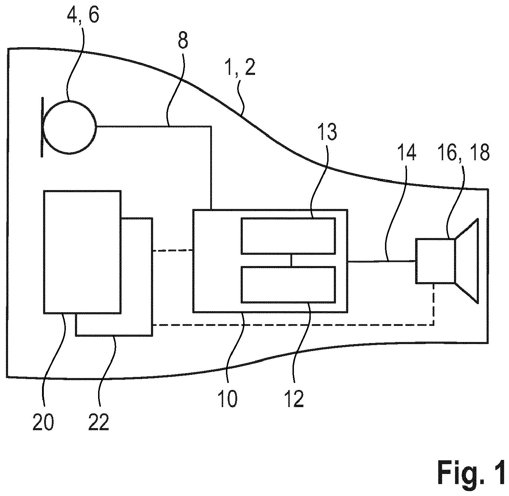

In Figur 1 ist schematisch in einem Blockschaltbild ein Hörinstrument 1 dargestellt, welches vorliegend als ein Hörgerät 2 zur Versorgung einer Hörschwäche eines Benutzers ausgestaltet ist. Das Hörgerät 2 umfasst dabei einen ersten elektroakustischen Eingangswandler 4, welcher vorliegend als ein Mikrofon 6 ausgestaltet ist, und dazu eingerichtet ist, im Betrieb des Hörgerätes 2 aus einem nicht näher dargestellten Umgebungsschall ein elektrisches Eingangssignal 8 zu erzeugen, wobei Oszillationen des Luftdrucks infolge der Schallwellen im Umgebungsschall in entsprechende Oszillationen einer Spannung und/oder eines Stromes des Eingangssignals 8 übersetzt werden. Das Hörgerät 2 weist weiter einen Signalverarbeitungseinheit 10 mit einem Signalprozessor 12 auf, welche dazu eingerichtet ist, im Betrieb des Hörgerätes 2 das Eingangssignal 8 benutzerspezifisch zu verarbeiten, und dabei insbesondere gemäß den audiologischen Anforderungen des Benutzers frequenzbandweise zu verstärken und/oder zu komprimieren. Die Signalverarbeitungseinheit 10 kann hierfür insbesondere aufgabenspezifische Schaltungen wie ASICs aufweisen, wobei allgemeinere Prozesse der Signalverarbeitung im Signalprozessor 12 durchgeführt werden, welcher hierfür zudem einen Speicher 13 der Signalverarbeitungseinheit 10 adressiert.

Durch die beschriebene Signalerarbeitung des Eingangssignals 8 wird ein Ausgangssignal 14 erzeugt, welches einem elektroakustischen Ausgangswandler 16 des Hörgerätes 2 zugeführt wird. Der Ausgangswandler 16, welcher vorliegend gegeben ist als ein Lautsprecher 18 (jedoch auch durch einen Knochenleithörer o.ä. gebildet sein kann), erzeugt im Betrieb des Hörgerätes 2 aus dem Ausgangssignal 14 ein nicht näher dargestelltes Ausgangsschallsignal, welches einem Gehör (ebenfalls nicht dargestellt) des Benutzers zugeführt wird.

Das als Hörgerät 2 ausgestaltete Hörinstrument 1 weist weiter eine wiederaufladbare Batteriezelle 20 auf, welche dazu eingerichtet und vorgesehen ist, im Betrieb des Hörgerätes 2 die nötige elektrische Leistung bereitzustellen und somit die elektrischen Komponenten, also insbesondere die Signalverarbeitungseinheit 10 und den Ausgangswandler 16 zu versorgen (gestrichelte Linien). Für besagte Versorgung über die Batteriezelle 20 weist das Hörgerät 2 zusätzlich ein Batteriemanagement 22 auf, welches mit der Batteriezelle 20 elektrisch verbunden ist und dazu eingerichtet ist, aus der Batteriezelle 20 eine jeweils angeforderte elektrische Leistung zu beziehen, und diese dem jeweiligen Verbraucher zuzuführen. Weiter ist das Batteriemanagement 22 auch dazu eingerichtet, bei einem Ladevorgang der Batteriezelle 20 den Leistungsfluss in die Batteriezelle 20 zu steuern, um z.B. für die Integrität der Batteriezelle 20 potentiell gefährliche Leistungsspitzen o.ä. zu verhindern.

Durch wiederholtes Aufladen der Batteriezelle 20 verschlechtert sich nach und nach deren maximale Kapazität, also insbesondere die maximale Ladung, welche durch die Batteriezelle 20 nach einem Ladezyklus für die elektrischen Verbraucher des Hörgerätes 2 bereitgestellt werden kann, bis ein erneuter Ladevorgang erforderlich ist. Dies kann dazu führen, dass der Benutzer mit einem Ladezyklus, der bei Inbetriebnahme des Hörgerätes 2 bspw. für einen reibungslosen Betrieb über einen Tag hinweg ausreichend war, ab einem gewisseren Grad der Alterung der Batteriezelle 20, also auch der Abnahme ihrer maximalen Kapazität bei Ladevorgängen, das Hörgerät 2 nicht mehr wie ursprünglich gewohnt verwenden und betreiben kann. Insbesondere könnten dabei im Betrieb des Hörgerätes 2 plötzlich Funktionen ausfallen, welche rechenintensive Algorithmen zur Signalverarbeitung erfordern, oder das Hörgerät 2 könnte den Betrieb ganz einstellen. Dies jedoch gerade auf Straßen, wo ein rechtzeitiges Hören von nahenden (Kraft-)Fahrzeugen auch für die Sicherheit wichtig ist, zu einem ernst zu nehmenden Problem werden.

In noch zu beschreibender Weise wird dem Benutzer nun eine Möglichkeit gegeben, eine fortgeschrittene Alterung der Batteriezelle 20 präzise zu erkennen, um die Batteriezelle ggf. auswechseln zu können, ohne dass ein solcher Wechsel dabei "nur sicherheitshalber" und somit ggf. viel zu früh erfolgen muss.

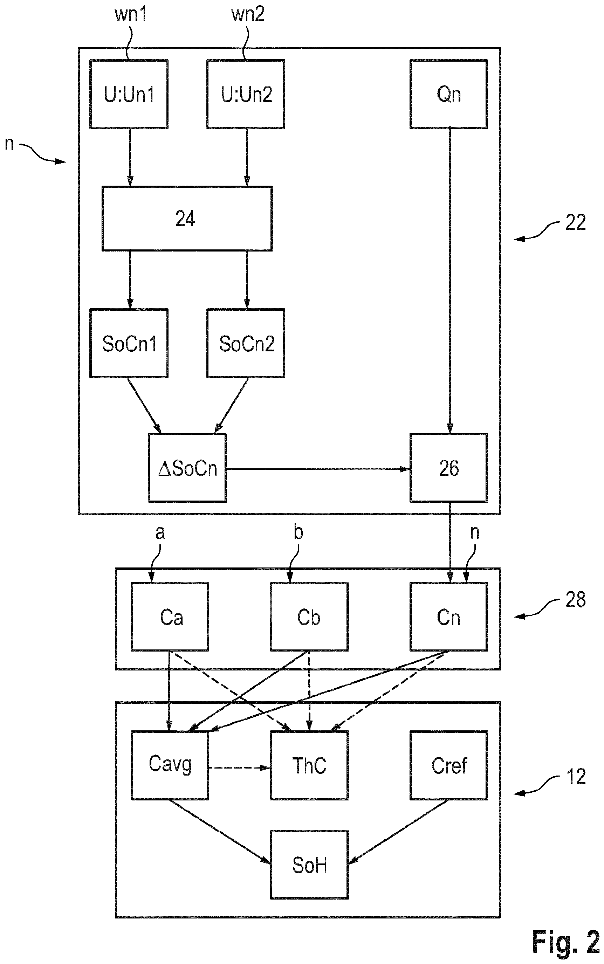

In Figur 2 ist in einem Blockdiagramm ein Verfahren dargestellt, mittels dessen für das Hörgerät 2 einen Alterungszustand der Batteriezelle 20 ermittelt werden kann. Für einen beliebigen Ladezyklus n wird durch das Batteriemanagement 22 eine Ladung Qn ermittelt, welche während des Ladezyklus n auf die Batteriezelle übertragen wird. Weiter werden durch das Batteriemanagement 22 zunächst als Ladekennwerte wn1, wn2 für den Ladezyklus n ein Startwert Un1 und ein Endwert Un2 einer Batteriespannung U der Batteriezelle 20 der Figur 1 bestimmt. Bei der Batteriespannung U kann es sich insbesondere um eine Leerlaufspannung bzw. eine Open-Circuit-Voltage handeln. Aus dem Startwert Un1 und dem Endwert Un2 der Batteriespannung U können mittels einer Lookup-Tabelle 24 jeweils ein Ausgangs-Ladezustand SoCn1 und ein Abschluss-Ladezustand SoCn2 ermittelt werden, welche also angeben, bei welcher Ladung oder welchem Ladezustand (z.B. prozentual, bezogen etwa auf das jeweilige momentane Maximum) der Ladezyklus n initiiert wurde, und bei welcher Ladung oder welchem Ladezustand der Ladezyklus n beendet wurde. Hieraus kann eine Änderung des Ladezustands ΔSoCn ermittelt werden, welche durch die im Ladezyklus n auf die Batteriezelle 20 übertragene Ladung Qn bewirkt wurde.

Die Änderung des Ladezustands ΔSoCn und/oder die im Ladezyklus n auf die Batteriezelle 20 übertragene Ladung Qn werden nun einem Verwendungskriterium 26 unterzogen. Das Verwendungskriterium 26 kann z.B. einen Schwellwertvergleich der Ladung Qn und/oder der Änderung des Ladezustands ΔSoCn und/oder einer Ladedauer mit einem entsprechenden Mindestwert beinhalten. Ist die übertragene Ladung Qn, die Änderung des Ladezustands ΔSoCn oder die Ladedauer zu gering, so werden die Daten des Ladezyklus n nicht weiter berücksichtigt. Wird das Verwendungskriterium 26 erfüllt, ist also die übertragene Ladung Qn, die Änderung des Ladezustands ΔSoCn oder die Ladedauer ausreichend hoch bzw. im Fall der Dauer ausreichend lange, so wird aus der Änderung des Ladezustands ΔSoCn und der übertragenen Ladung Qn durch Division ein Kapazitätskennwert Cn gebildet.

Der Kapazitätskennwert Cn gibt dabei infolge der Normierung der Änderung des Ladezustands ΔSoCn, welche im Ladezyklus n durch die Ladung Qn bewirkt wird, über ebendiese Ladung Qn Aufschluss über die maximale Kapazität zum Zeitpunkt, an welchem der Ladezyklus n erfolgte. Dieser Kapazitätskennwert Cn für den Ladezyklus n wird nun in einem FIFO-Speicher 28 abgelegt, welcher physisch insbesondere auf dem Speicher 13 realisiert sein kann.

Durch den Signalprozessor 12 werden nun die Kapazitätskennwerte Ca, Cb, ..., Cn zumindest der letzten fünf, bevorzugt auch der letzten zehn Ladezyklen a, b, ...n gemittelt, wobei die Mittelwertbildung ggf. auch gewichtet (mit größerem Gewicht auf aktuelleren Ladezyklen) oder rekursiv erfolgen kann, und dabei eine gemittelte Ladekapazität Cavg gebildet. Hierbei kann noch eine Kontrolle erfolgen, ob einer der Kapazitätskennwerte Ca, Cb, ..., Cn ggf. einen statistischen Ausreißer bildet, indem etwa die verwendeten Kapazitätskennwerte Ca, Cb, ..., Cn jeweils einzeln mit der gemittelten Ladekapazität Cavg verglichen werden, und dabei überprüft wird, ob eine Abweichung unter einem vorgegebenen Grenzwert ThC bleibt (gestrichelte Pfeile). Ist dies nicht der Fall, kann der betreffende Kapazitätskennwert vernachlässigt werden, und die gemittelte Ladekapazität Cavg erneut (also ohne den Beitrag des derart ausgesonderten "Ausreißers") gebildet werden.

Die gemittelte Ladekapazität Cavg wird nun mit einem Referenzwert Cref für eine ursprüngliche Kapazität der Batteriezelle 20 verglichen, um so den Alterungszustand SoH der Batteriezelle 20 zu erhalten. Der Referenzwert Cref kann dabei etwa durch eine Herstellerangabe bezogen werden, oder auch ähnlich zur vorbeschriebenen Weise im ersten Ladezyklus nach einer Inbetriebnahme aus den Ladekennwerten ermittelt werden. Bevorzugt wird für den Alterungszustand SoH der Batteriezelle 20 der die gemittelte Ladekapazität Cavg durch den Referenzwert Cref dividiert. Hierdurch gibt der Alterungszustand SoH einen prozentualen Wert der aktuell möglichen Kapazität (wiedergegeben durch die gemittelte Ladekapazität Cavg) bezogen auf den ursprünglichen Wert an.

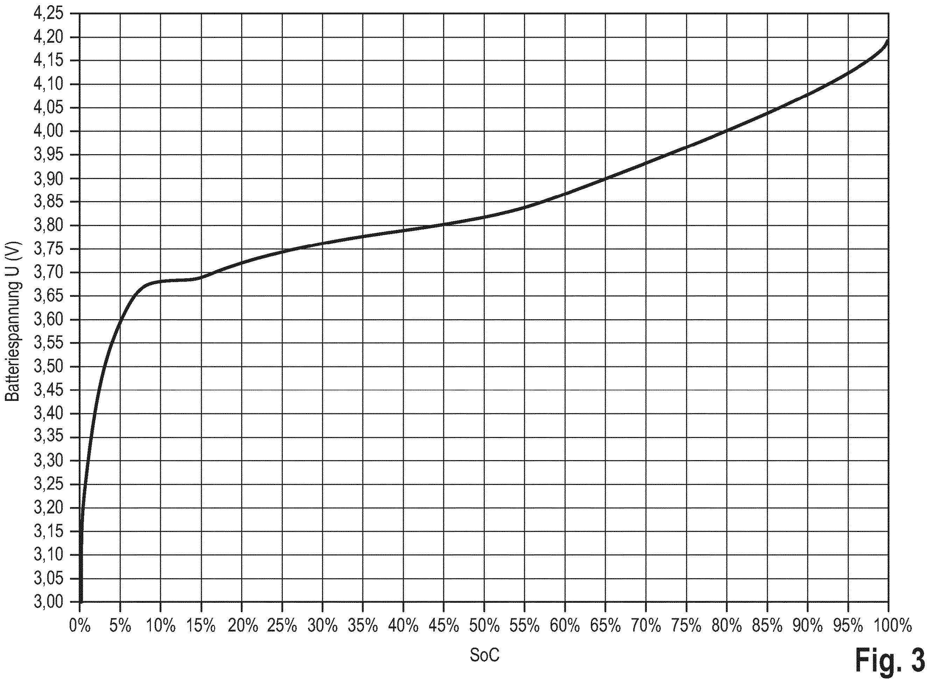

In Figur 3 ist in einem Diagramm eine Batteriespannung U der Batteriezelle 20 (in Volt) nach Figur 1 gegen den Ladezustand Soc (in %) aufgetragen. Man erkennt einen klar nichtlinearen Zusammenhang, wobei für sehr geringe Werte des Ladezustands SoC die Batteriespannung zunächst stark ansteigt, und danach die Anstiege deutlich moderater werden. Dieses nichtlineare Verhalten ist bei der Bildung der Lookup-Tabelle 24 für das Verfahren nach Figur 2 besonders zu berücksichtigen, um Fehler infolge der für die Lookup-Tabelle 24 erforderlichen Diskretisierung möglichst zu minimieren.

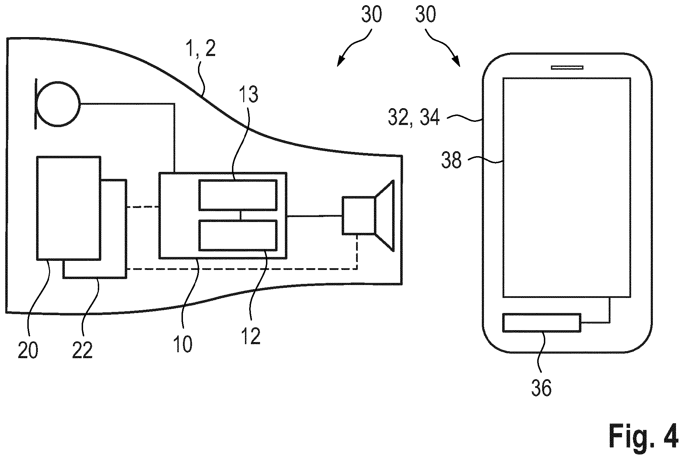

In Figur 4 ist ein Hörsystem 30 dargestellt, welches das Hörgerät 2 nach Figur 1 umfasst. Zusätzlich umfasst das Hörsystem 30 auch ein vorliegend als Smartphone 32 ausgestaltetes Hilfsgerät 34, auf dessen Signalprozessor 36 anhand der Kapazitätskennwerte Ca, Cb, ... Cn wenigstens Teile der Berechnungen des Verfahrens nach Figur 2 durchgeführt werden können, wofür die besagten Kapazitätskennwerte Ca, Cb, ... Cn über eine nicht näher dargestellte Datenverbindung vom Hörgerät 2 an das Smartphone 32 übertragen werden. Zudem kann der Alterungszustand SoH der Batteriezelle 20 des Hörgerätes 2 (auch unabhängig von einer Verwendung des Signalprozessors 36 für das Verfahren nach Figur 2) auf einem Bildschirm 38 des Smartphones 32 dem Benutzer angezeigt werden (etwa in einer entsprechenden App zur Steuerung des Hörgerätes 2).

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 1: Hörinstrument
- 2: Hörgerät
- 4: Eingangswandler
- 6: Mikrofon
- 8: Eingangssignal
- 10: Signalverarbeitungseinheit
- 12: Signalprozessor
- 13: Speicher
- 14: Ausgangssignal
- 16: Ausgangswandler
- 18: Lautsprecher
- 20: Batteriezelle
- 22: Batteriemanagement
- 24: Lookup-Tabelle
- 26: Verwendungskriterium
- 28: FIFO-Speicher
- 30: Hörsystem
- 32: Smartphone
- 34: Hilfsgerät
- 36: Signalprozessor
- 38: Bildschirm

- a, b, n: Ladezyklus
- Ca, Cb, Cn: Kapazitätskennwert
- Cavg: gemittelte Ladekapazität
- Cref: Referenzwert (für eine ursprüngliche Kapazität)
- Qn: Ladung
- SoC: Ladezustand
- SoCn1/2: Ausgangs-/Abschluss-Ladezustand
- SoH: Alterungszustand (der Batteriezelle)
- ThC: vorgegebener Grenzwert
- U: Batteriespannung
- Un1/2: Start-/Endwert (der Batteriespannung)
- wn1/2: Ladekennwert
- ΔSoCn: Änderung des Ladezustands

## Patentansprüche

1. Verfahren zum Ermitteln eines Alterungszustandes (SoH) einer Batteriezelle (20), welche in einem Hörinstrument (1) verwendet wird,
wobei für eine Mehrzahl an Ladezyklen (a, b, n) jeweils
- durch ein Batteriemanagement (22) des Hörinstrumentes (1) eine auf die Batteriezelle (20) übertragene Ladung (Qn) ermittelt wird,
- durch das Batteriemanagement (22) eine Anzahl an Ladekennwerten (wn1, wn2) ermittelt werden, welche Aufschluss über die von besagter Ladung (Qn) bewirkte Änderung eines Ladezustands (ΔSoCn) der Batteriezelle liefert, und
- anhand der übertragenen Ladung (Qn) und besagter Anzahl an Ladekennwerten (wk1, wk2) ein Kapazitätskennwert (Ca, Cb, Cn) ermittelt wird, welcher eine Kenngröße für eine momentane Ladefähigkeit der Batteriezelle bildet,
wobei durch einen Signalprozessor (12) des Hörinstrumentes (1) oder durch einen Signalprozessor (36) eines mit dem Hörinstrument (1) assoziierten Hilfsgerätes (34) an einem bestimmten Zeitpunkt die jeweiligen Kapazitätskennwerte (Ca, Cb, Cn) wenigstens einiger der vergangenen zehn Ladezyklen (a, b, n) gemittelt werden, und hieraus eine gemittelte Ladekapazität (Cavg) gebildet wird, und
wobei die gemittelte Ladekapazität (Cavg) mit einem Referenzwert (Cref) verglichen wird, welcher eine Kenngröße für eine ursprüngliche Kapazität der Batteriezelle (20) bildet, und hieraus der Alterungszustand (SoH) der Batteriezelle (20) bestimmt wird.

2. Verfahren nach Anspruch 1,
wobei für den jeweiligen Ladezyklus (n)
- anhand der Anzahl an Ladekennwerten (wk1, wk2) die Änderung des Ladezustands (ΔSoCn) der Batteriezelle (20) ermittelt wird, welche von der auf die Batteriezelle (20) übertragenen Ladung (Qn) bewirkt wird, und
- wobei der Kapazitätskennwert (Ca, Cb, Cn) anhand der übertragenen Ladung (Qn) und anhand der Änderung des Ladezustands (ΔSoCn) der Batteriezelle (20) ermittelt wird.

3. Verfahren nach Anspruch 1 oder Anspruch 2,
wobei für den jeweiligen Ladezyklus (n) als die Anzahl an Ladekennwerten (wn1, wn2)
- ein zu Beginn des betreffenden Ladezyklus' (n) vorliegender Startwert (Un1) einer Batteriespannung (U) der Batteriezelle (20) sowie
- ein am Ende des betreffenden Ladezyklus' (n) vorliegender Endwert (Un2) der Batteriespannung (U)
erfasst werden.

4. Verfahren nach Anspruch 1 oder Anspruch 2,
wobei für den jeweiligen Ladezyklus (n) als die Anzahl an Ladekennwerten (wn1, wn2) eine Mehrzahl an instantanen Werten der Batteriespannungen (U) der Batteriezelle (20) zu vorab festgelegten Zeitpunkten erfasst werden.

5. Verfahren nach Anspruch 3 oder Anspruch 4,
wobei für den jeweiligen Ladezyklus (n)
- anhand des Startwertes (Un1) der Batteriespannung (U) ein Ausgangs-Ladezustand (SoCn1) der Batteriezelle (20) ermittelt wird, und anhand des Endwertes (Un2) der Batteriespannung (U) ein Abschluss-Ladezustand (SoCn2) der Batteriezelle (20) ermittelt wird, oder
- anhand der instantanen Werte der Batteriespannungen (U) eine Mehrzahl entsprechender instantaner Ladezustände der Batteriezelle (20) für die vorab festgelegten Zeitpunkte ermittelt wird,
und wobei anhand des Ausgangs-Ladezustands (SoCn1) und des Abschluss-Ladezustands (SoCn2) bzw. anhand der instantanen Ladezustände die während des betreffenden Ladezyklus (n) von der übertragenen Ladung (Qn) bewirkte Änderung des Ladezustands (ΔSoCn) der Batteriezelle (20) ermittelt wird.

6. Verfahren nach Anspruch 5,
wobei der Ausgangs-Ladezustand (SoCn1) bzw. der Abschluss-Ladezustand (SoCn2) aus dem Startwert (Un1) bzw. dem Endwert (Un2) der Batteriespannung (U) mittels einer Lookup-Tabelle (24) ermittelt werden.

7. Verfahren nach einem der Ansprüche 3 bis 6,
wobei als Batteriespannung (U) eine Leerlaufspannung und/oder eine Spannung einer Ladeschaltung und/oder eine Spannung einer Entladeschaltung erfasst werden.

8. Verfahren nach einem der vorhergehenden Ansprüche,
wobei das Mitteln der jeweiligen Kapazitätskennwerte (Ca, Cb, Cn) durch einen gewichteten und/oder rekursiven Mittelwert erfolgt.

9. Verfahren nach einem der vorhergehenden Ansprüche,
wobei als besagter Referenzwert (Cref) ein initialer Wert für den besagten Kapazitätskennwert (Ca, Cb, Cn) verwendet wird, welcher in einem der ersten zehn Ladezyklen (a, b, n) nach Inbetriebnahme der Batteriezelle (20) im Hörinstrument (1) ermittelt wird, oder
wobei als besagter Referenzwert (Cref) eine Herstellerangabe der ursprünglichen Kapazität verwendet wird.

10. Verfahren nach einem der vorhergehenden Ansprüche,
wobei für einen Ladezyklus (a, b, n) ein Verwendungskriterium (26) überprüft wird, und
wobei der Kapazitätskennwert (Ca, Cb, Cn) des betreffenden Ladezyklus (a, b, n) weiter in Abhängigkeit eines Bestehens des Verwendungskriteriums (26) gebildet wird.

11. Verfahren nach Anspruch 10,
wobei als Verwendungskriterium (26)
- eine Ladedauer des Ladezyklus (a, b, n) und/oder
- die während des Ladezyklus' (a, b, n) übertragene Ladung (Qn) und/oder
- der Endwert (Un2) der Batteriespannung (U) und/oder
- der Abschluss-Ladezustand (SoCn2) der Batteriezelle (20) überprüft wird.

12. Verfahren nach einem der vorhergehenden Ansprüche,
wobei ein Kapazitätskennwert (Ca, Cb, Cn) bei einer Mittelwertbildung für die gemittelte Ladekapazität (Cavg) vernachlässigt wird, wenn seine Abweichung vom Mittelwert einen vorgegebenen Grenzwert (ThC) überschreitet.

13. Verfahren nach einem der vorhergehenden Ansprüche,
wobei für die Bildung der gemittelten Ladekapazität (Cavg) die besagte Mehrzahl an Kapazitätskennwerten (Ca, Cb, Cn) in einen First-In-First-Out-Speicher (28) gespeichert wird, welcher durch den Signalprozessor (12) des Hörinstrumentes (1) bzw. durch den Signalprozessor (36) des mit dem Hörinstrument (1) assoziierten Hilfsgerätes (34) adressierbar ist, und/oder dessen Speicherkapazität genau der besagten Mehrzahl an Kapazitätskennwerten (Ca, Cb, Cn) entspricht.

14. Hörsystem (30), umfassend:
- ein Hörinstrument (1) mit einer Batteriezelle (20) und einem Batteriemanagement (22), sowie
- einem Signalprozessor (12, 36),
wobei das Hörsystem (30) zur Durchführung des Verfahrens nach einem der vorhergehenden Ansprüche eingerichtet ist.

15. Hörsystem (30) nach Anspruch 14, weiter umfassend ein mit dem Hörinstrument (1) assoziiertes Hilfsgerät (34), welches besagten Signalprozessor (36) aufweist.

16. Hörsystem (30) nach Anspruch 15,
wobei das Hilfsgerät (34) durch ein Smartphone (32) oder eine Smartwatch gegeben ist.
